(19) **Europäisches Patentamt**

**European Patent Office**

**Office européen des brevets**

(11) **EP 0 807 190 B1**

(12) **EUROPÄISCHE PATENTSCHRIFT**

(45) Veröffentlichungstag und Bekanntmachung des Hinweises auf die Patenterteilung:
**06.02.2002 Patentblatt 2002/06**

(51) Int Cl.⁷: **C23C 18/20**, C23C 18/18

(21) Anmeldenummer: **96941031.5**

(86) Internationale Anmeldenummer:
**PCT/EP96/05220**

(22) Anmeldetag: **26.11.1996**

(87) Internationale Veröffentlichungsnummer:
**WO 97/20084 (05.06.1997 Gazette 1997/24)**

(54) **VERFAHREN ZUR HERSTELLUNG VON METALLISIERTEN WERKSTOFFEN**

PROCESS FOR PRODUCING METAL-COATED MATERIALS

PROCEDE DE PRODUCTION DE MATERIAUX METALLISES

(84) Benannte Vertragsstaaten:
**AT BE CH DE FR GB IT LI NL SE**

(30) Priorität: **29.11.1995 DE 19544543**

(43) Veröffentlichungstag der Anmeldung:
**19.11.1997 Patentblatt 1997/47**

(73) Patentinhaber: **Zipperling Kessler & Co (GmbH & Co)**
**D-22926 Ahrensburg (DE)**

(72) Erfinder: **WESSLING, Bernhard**
**D-22941 Bargteheide (DE)**

(74) Vertreter: **UEXKÜLL & STOLBERG**
**Patentanwälte Beselerstrasse 4**
**22607 Hamburg (DE)**

(56) Entgegenhaltungen:
**US-A- 5 373 629**

• **JOURNAL OF VACUUM SCIENCE AND TECHNOLOGY: PART B, Bd. 9, Nr. 6, 1.November 1991, Seiten 3428-3431, XP000268560 ANGELOPOULOS M ET AL: "LITHOGRAPHIC APPLICATIONS OF CONDUCTING POLYMERS"**
• **DATABASE WPI Section Ch, Week 8730 Derwent Publications Ltd., London, GB; Class A35, AN 87-211397 XP002027770 & JP 62 139 896 A (FURUKAWA ELECTRIC CO) , 23.Juni 1987**
• **DATABASE WPI Section Ch, Week 9518 Derwent Publications Ltd., London, GB; Class A85, AN 95-135018 XP002027771 & JP 07 058 478 A (INOAC CORP KK) , 3.März 1995**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung betrifft ein Verfahren zur Herstellung von metallisierten Werkstoffen und insbesondere ein solches Verfahren, bei dem das gewünschte Metall in nicht-elektrochemischer Weise auf dem Werkstoff abgeschieden wird.

Das Aufbringen von Metallschichten auf nichtleitfähige Werkstoffe oder leitfähige Werkstoffe, wie Metalle, ist eine in vielen Industriezweigen erforderliche und in unterschiedlichsten Varianten praktizierte Technik. Ziel dieser Behandlung ist es insbesondere, antistatische oder leitfähige Oberflächen zu erhalten oder eine elektromagnetische Abschirmung zur Verfügung zu stellen. Weiter kann das Metallisieren zur Erzielung eines gewünschten optischen Effekts, wie eines metallischen "look", oder zum Erhalt von vergüteten oder abriebfesteren Oberflächen dienen. Schließlich hat die Metallisierung von Werkstoffoberflächen auch bei der Herstellung von Leiterplatten eine große Bedeutung.

Zur Durchführung der Metallisierung, d.h. dem Aufbringen des Metalles auf den Werkstoff, sind neben elektrochemischen auch nicht-elektrochemische Verfahren bekannt, die auch als chemische Abscheidungsverfahren bezeichnet werden. Derartigen chemischen Verfahren geht in der Regel eine geeignete Oberflächenbehandlung des Werkstoffes voraus, und sie sind für verschiedene Metalle wie An, Ag, Pd, Cu, Sn oder Ni bekannt. Häufig werden nach vorangehender chemischer Metallisierung noch zusätzlich elektrochemische Methoden angewendet, um die Shichtdicke der aufgebrachten Metalle zu verstärken.

Aus Journal of Vacuum Science and Technology Part B, Bd. 9, Nr. 6, November 1991, Seiten 3428-3431, ist es bekannt, dass Polyanilin für die nicht-elektrochemische Abscheidung von Edelmetallen eingesetzt werden kann. Hierzu wird das Polyanilin in eine wässrige Lösung von Palladium- oder Silbersalzlösung eingetaucht, woraufhin die Edelmetall-Ionen reduziert werden und sich dünne Schichten des Edelmetalls auf dem Polyanilin abscheiden.

Die bekannten chemischen Verfahren führen jedoch bei verschiedenen Anwendungen zu mangelhaften Eigenschaften bei den aufgebrachten Metallschichten oder den metallisierten Werkstoffen. So sind die erhaltenen Schichten häufig nur unregelmäßig aufgebaut oder sie zeigen eine mangelnde Elastizität oder zu große Sprödigkeit. Weiter sind die bekannten Verfahren wenig effizient, da sie häufig den Einsatz von großen Mengen zumeist toxischer Chemikalien erforden.

Der Erfindung liegt daher die Aufgabe zugrunde, ein nichtelektrochemisches Verfahren zur Herstellung von metallisierten Werkstoffen zur Verfügung zu stellen, welches hinsichtlich der vorstehend genannten Gesichtspunkte den bekannten Verfahren überlegen ist.

Diese Aufgabe wird überraschenderweise durch das erfindungsgemäße Verfahren nach den Ansprüchen 1 bis 10 gelöst.

Die Erfindung betrifft außerdem die Verwendung von intrinsisch leitfähigen Polymeren bei der nichtelektrochemischen Aufbringung von Metallen auf Werkstoffe gemäß den Ansprüchen 11 und 12.

Das erfindungsgemäße Verfahren zur Herstellung von metallisierten Werkstoffen zeichnet sich dadurch aus, daß man

(a) den zu metallisierenden Werkstoff mit einer Beschichtung versieht, die intrinsisch leitfähiges Polymer enthält,

(b) das intrinsisch leitfähige Polymer durch Reduktion aktiviert und

(c) das Metall auf den Werkstoff in nicht-elektrochemischer Weise aufbringt, indem der beschichtete Werkstoff mit einer Ionen des Metalles enthaltenden Lösung in Kontakt gebracht wird.

Unter den im Verfahren eingesetzten "intrinsisch leitfähigen Polymeren" werden solche organischen Polymere verstanden, die polykonjugierte Bindungssysteme, z.B. Doppelbindungen, aromatische oder heteroaromatische Ringe oder Dreifachbindungen, aufweisen. Beispiele für solche Polymere sind Polydiacetylen, Polyacetylen (PAc), Polypyrrol (PPy), Polyanilin (PAni), Polythiophen (PTh), Polyisothianaphthen (PITN), Polyheteroarylenvinylen (PArV), wobei die Heteroarylen-Gruppe z.B. Thiophen oder Pyrrol sein kann, Poly-p-phenylen (PpP), Polyphenylensulfid (PPS), Polyperinaphthalin (PPN), Polyphthalocyanin (PPhc) sowie deren Derivate (die z.B. aus substituierten Monomeren aufgebaut sind), deren Copolymere und deren physikalische Mischungen. Sie können in verschiedenen Zuständen vorliegen, die durch jeweils unterschiedliche Summenformeln beschrieben werden und durch Reaktionen wie Oxidation, Reduktion, Säure-/Basereaktion oder Komplexbildung zumeist im wesentlichen reversibel ineinander überführt werden können. Diese Reaktionen werden in der Literatur gelegentlich auch als "Dotierung" bzw. "Kompensation" bezeichnet. Zumindest einer der möglichen Zustände ist elektrisch sehr gut leitfähig, z.B. mit einer Leitfähigkeit von mehr als 1 S/cm (als reiner Stoff), so daß von intrinsisch leitfähigen Polymeren gesprochen werden kann. Bisweilen werden die intrinsisch leitfähigen Polymere in der Literatur auch als "organische Metalle" bezeichnet.

Einen guten Überblick über bis heute bereits synthetisierte intrinsisch leitfähige Polymere, die erfindungsgemäß geeignet sind, findet man z.B. in Synthetic Metals, Hefte 17, 18 und 19 (1987).

Die in Stufe (a) aufgebrachte Beschichtung kann insbesondere ein Polymerblend mit Gehalt an intrinsisch leitfähigem Polymer sein. Neben intrinsisch leitfähigem Polymer enthalten die erfindungsgemäß eingesetzten Polymerblends weitere Polymere, Copolymere oder Polymermischungen, wie z.B. Polyamide, Polyester, Polyether, wie Polyethylenoxide, Copolymer-Latices auf wäßriger Basis, wie z.B. Vinylacetatbutylacrylat, oder andere Copolymer-Latices, und/oder Polyvinylalkohole. Besonders bevorzugte weitere Polymere sind Polyamide.

Vorteilhafte Polymerblends haben einen Gehalt von vorzugsweise 0,1 bis 45 Gew.-% und besonders bevorzugt 5 bis 35 Gew.-% intrinsisch leitfähigem Polymer.

Es ist ebenfalls möglich, daß als Beschichtung reine intrinsisch leitfähige Polymere verwendet werden.

Als besonders vorteilhaft hat es sich auch erwiesen, wenn das intrinsisch leitfähige Polymer in Form einer Dispersion eingesetzt wird. Dabei kann es sich um eine Dispersion in organischen Lösungsmitteln, wie Alkoholen oder N-Methylpyrrolidon, oder in wäßrigen Lösungsmitteln handeln. Die Dispersionen können auch Bindemittel, wie polymere oder filmbildende Bindemittel, z.B. die oben als Komponente von Polymerblends angegebenen weiteren Polymere, enthalten.

Als bevorzugtes intrinsisch leitfähiges Polymer wird Polyanilin eingesetzt.

Zur Aufbringung der Beschichtung können übliche Verfahren, wie z.B. mechanisches Auftragen mit einem Rakel oder Eintauchen in Lösungen oder Dispersionen von intrinsisch leitfähigem Polymer, dienen.

In Verfahrensstufe (b) erfolgt eine Aktivierung des intrinsisch leitfähigen Polymers, indem dieses reduziert wird. Dabei kann die Reduktion z. B. auf elektrochemischem Wege, d.h. mit Hilfe eines von außen angelegten elektrischen Stromes erfolgen. Es ist jedoch bevorzugt, daß die Reduktion durch Einsatz von chemischen Reduktionsmitteln durchgeführt wird. Als chemische Reduktionsmittel kommen dabei insbesondere $H_2$, Hydride, wie Borhydride, z.B. $BH_3$, und/oder gegenüber dem intrinsisch leitfähigen Polymer reduzierend wirkende Metalle, z.B. Eisen, Aluminium oder Kupfer, in Frage. Ob ein Metall gegenüber dem Polymer reduzierend wirkt, hängt dabei natürlich von den konkret gewählten Bedingungen ab, unter denen die Reduzierung erfolgt. Einen wichtigen Einfluß können dabei z.B. der pH-Wert und das Vorliegen von Komplexierungsmitteln ausüben.

Als besonders bevorzugte Reduktionsmittel haben sich Hydrazin und Hydrazin-Verbindungen, wie Hydrazin-Salze, z.B. Hydraziniumsulfat, erwiesen.

Zur Verbesserung der Stabilität und Reproduzierbarkeit der Aktivierung erfolgt die Reduktion vorzugsweise in einem entgasten, d.h. sauerstoffarmen oder -freien Medium. Jedoch sind auch spezielle Anwendungen des Verfahrens denkbar, in denen die Anwesenheit von Sauerstoff nicht nachteilig, sondern sogar wünschenswert ist.

Im Falle des bevorzugt als intrinsisch leitfähiges Polymer eingesetzten Polyanilins ist die Reduktion häufig auch an einer Farbänderung zu erkennen, die auf die Bildung der reduzierten Form des Polyanilins, des sogenannten Leucoemeraldins, zurückgeht.

In Verfahrensstufe (c) wird das ausgewählte Metall in nicht-elektrochemischer Weise auf den Werkstoff aufgebracht, indem der beschichtete Werkstoff mit einer Metallionen enthaltenden Lösung in Kontakt gebracht wird.

Üblicherweise wird diese Verfahrensstufe nach der Stufe (b) durchgeführt. Es ist jedoch auch möglich, daß gleichzeitig mit der Reduktion auch bereits das nicht-elektrochemische Aufbringen des Metalles auf den beschichteten Werkstoff erfolgt. Ein Beispiel hierfür ist die erfindungsgemäße Verzinnung von Kupfer, wie sie weiter unten und in den Beispielen näher erläutert ist. In manchen Fällen kann die gleichzeitige Durchführrung von (b) und (c) jedoch z.B. aufgrund der Unverträglichkeit von in (b) und (c) eingesetzten Chemikalien miteinander oder wegen verfahrenstechnischer Gesichtspunkte nicht erwünscht sein.

Unter Aufbringung in "nicht-elektrochemischer Weise" wird ein Verfahren verstanden, bei dem die Aufbringung nicht durch Einsatz von einem von außen angelegten elektrischen Strom erfolgt. Vielmehr wird der mit der polymerhaltigen Beschichtung versehene Werkstoff mit der Metallionen-Lösung in Kontakt gebracht, wofür üblicherweise einfaches Eintauchen in die Lösung ausreicht.

Bevorzugt handelt es sich bei der Lösung um eine solche von ein- oder zweiwertigen Kationen des Metalles und insbesondere wird eine wäßrige Lösung mit einem pH-Wert von < 7 eingesetzt.

Das erfindungsgemäße Verfahren gestattet die einfache und effiziente Metallisierung von Werkstoffen mit Metallen, und es hat sich insbesondere bei Aufbringung von Cu, Ag, Pd, Sn, Pt und/oder Ni als vorteilhaft erwiesen. Besonders bevorzugt dient das Verfahren zur Aufbringung von Cu, Ag oder Sn.

Als Werkstoffe kommen vornehmlich Kunststoffe aller Art, insbesondere solche mit Gehalt an Polyamid oder Polyethylenterephthalat, Gläser oder Keramiken in Frage. Es können aber auch andere Werkstoffe, wie z.B. metallische Werkstoffe, mit dem erfindungsgemäßen Verfahren metallisiert werden.

Zum Mechanismus des erfindungsgemäßen Verfahrens wird angenommen, daß das reduzierte intrinsisch leitfähige Polymer der Beschichtung als Elektronenüberträger und somit als Katalysator fungiert und das eingesetzte Reduktionsmittel nicht direkt mit den Ionen des abzuscheidenden Metalls wechselwirkt bzw. diese nicht direkt reduziert. Die Elektronenübertragung vom intrinsisch leitfähigen Polymer auf die Metallkationen resultiert dann in einer Abscheidung von elementarem Metall auf dem beschichteten Werkstoff. Die damit einhergehende Oxidation des leitfähigen Polymeren führt zumindest teilweise zu einer Regenerierung des eingesetzten leitfähigen Polymers und eröffnet die Möglichkeit, dieses erneut den Reduktions- und Abscheidungsstufen (b) und (c) zu unterwerfen. Angesichts dieses vorgeschlagenen Reaktionsmechanismuses kann man somit von einer katalytischen Aktivität des intrinsisch leitfähigen Polymeren sprechen.

Besonders illustrativ für die überraschende katalytische Funktionsweise der Beschichtung mit intrinsisch leitfähigem Polymer ist die erfindungsgemäße Zinnabscheidung auf Kupfer.

Bei der konventionellen nicht-elektrochemischen Verzinnung von Kupfer verwendet man üblicherweise z. B. methansulfonsaure thioharnstoffhaltige $Sn^{2+}$-Lösungen. Die Aufgabe des Thioharnstoffs ist dabei offenbar, durch Komplexbildung mit Cu(+I) die Auflösung des Kupfers zu ermöglichen, da Methansulfonsäure allein Kupfer nicht auf- oder anlöst. Weiter wird aufgrund des negativeren Potentials des Cu(I)-Thioharnstoffkomplexes relativ zu unkomplexiertem Cu(I) ein Elektronentransfer zum $Sn^{2+}$ und damit dessen Reduktion zu $Sn^0$ ermöglicht.

Ausgedrückt in Mol muß bei dieser Verzinnung von Kupfer theoretisch doppelt soviel Cu aufgelöst werden, wie man Sn abscheiden will. Tatsächlich ergibt aber eine sorgfältige Analyse des Anstiegs der Cu(II)-Konzentration und des Absinkens der Sn(II)-Konzentration in der Verzinnungslösung im Verlaufe des Verzinnens größerer Cu-Flächen in betrieblichen Anwendungen anstelle eines Cu(II):Sn(abgeschieden)-Verhältnisses von 2 ein solches von 1,22. Die Ursache hierfür ist in der Literatur bisher nicht bekannt.

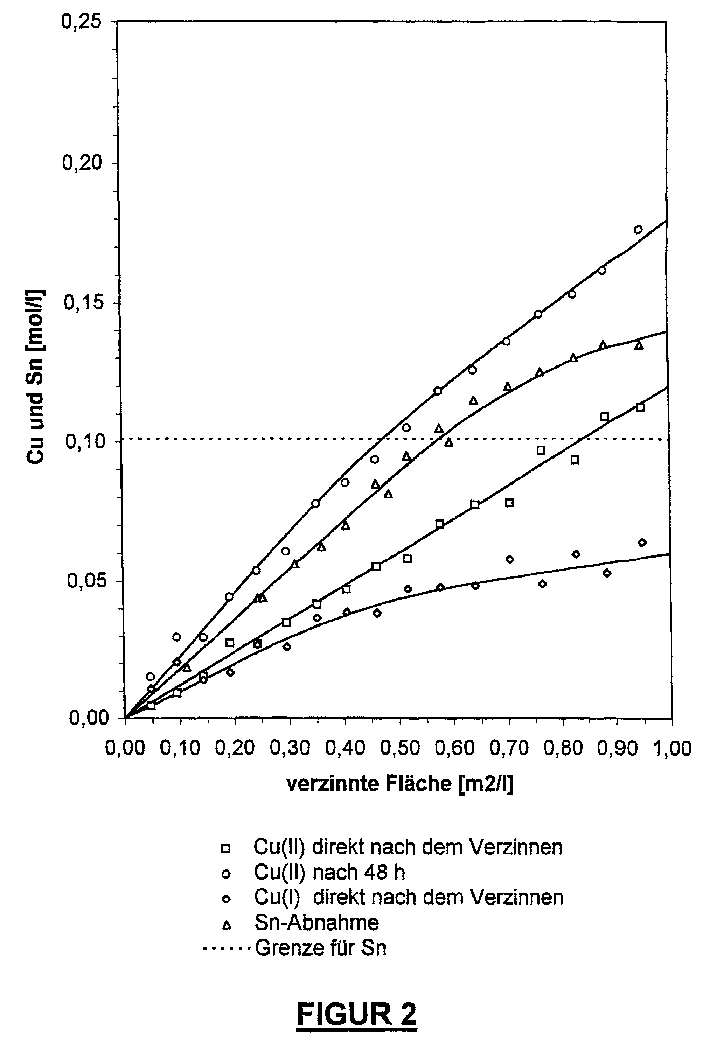

Wie Fig. 2 zeigt, weicht der Anstieg der Cu(II)- und die Abnahme der Sn(II)-Konzentration bei der konventionellen nicht-elektrochemischen Verzinnung von der anfänglich korrekten linearen Entwicklung oberhalb bestimmter Konzentrationen ab. Hierbei handelt es sich um das aus der technischen Literatur und den Hinweisen der Hersteller bekannte Phänomen, daß die Verzinnung oberhalb einer Cu-Konzentration von 0,08 Mol/l bzw. unterhalb einer Sn(II)-Konzentration von 0,1 Mol/l nicht mehr wunschgemäß verläuft, und das Verzinnungsbad daher dann nicht mehr verwendet werden kann, sondern erneuert werden muß. Zur Erklärung wird angegeben, daß sich außerhalb der empfohlenen Konzentrationsbereiche anstelle reiner Zinnschichten unerwünschte intermetallische Phasen ($Sn_x/Cu_y$) abscheiden. Die Funktion des Zinns auf der Kupferschicht ist dann nicht mehr gewährleistet.

Besonders stark zeigt sich die Abweichung vom linearen Verhalten, wenn man anstelle der Gesamtkonzentration des Cu(II) - die man aus chemischen Gründen erst nach einigen Tagen, wenn die gesamte Cu(I)-Menge durch Luftsauerstoff zu Cu(II) umgewandelt wurde, bestimmen kann - diejenige Cu(II)-Menge erfaßt, die unmittelbar während des Beschichtungsablaufes auftritt. Hierbei erfaßt man gewissermaßen die Dynamik der Cu(I)/Cu(II)-Reaktionen, wobei die Differenz zwischen der Gesamtmenge an gelösten Kupfer-Ionen und derjenigen, die wir als "dynamisch" bezeichnen wollen, Cu(I) ist. Diese Kurve ist in Figur 2 mit "Cu(I) nach dem Verzinnen" bezeichnet, und sie ist besonders nicht-linear, sobald die kritische Cu-Konzentration erreicht wird.

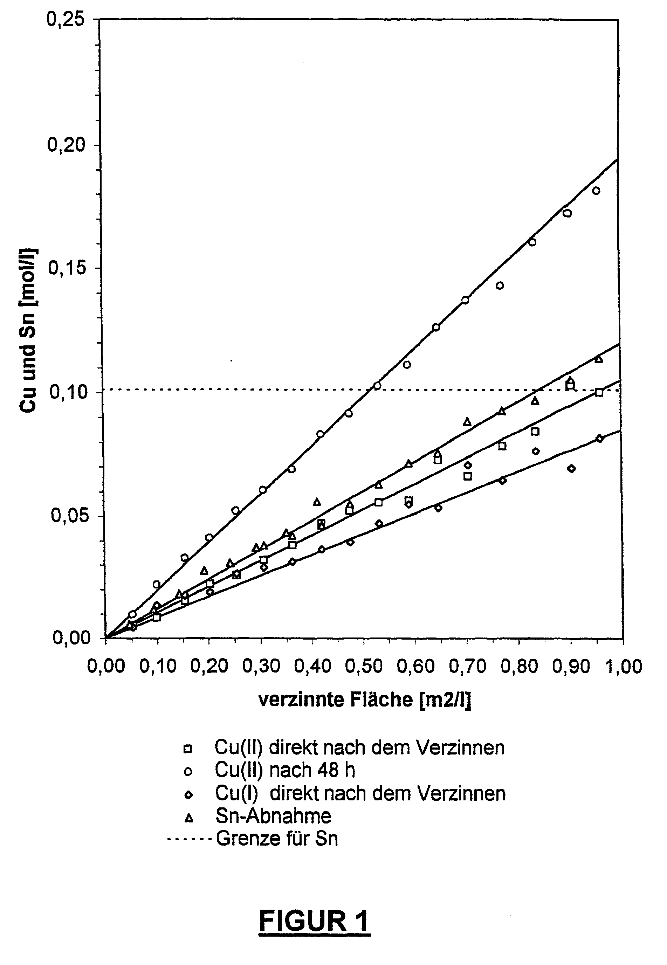

Verwendet man nun anstelle unbeschichteter Kupferflächen solche, die erfindungsgemäß mit einer dünnen Beschichtung mit leitfähigem Polymer versehen sind, welches unter den Verzinnungsbedingungen durch das Kupfer reduziert wird, so zeigt sich ein ganz anderes Verhalten. Nunmehr nähert sich das Cu(II):Sn(abgeschieden)-Verhältnis dem idealen Wert von 2 an und beträgt 1,63. Darüber hinaus ist, wie Fig. 1 zeigt, der Verlauf des Anstiegs der gesamt-Cu(II)- und auch der dynamischen Cu(I)-Konzentration sowie das Absinken der Sn(II)-Konzentration über den gesamten Konzentrationsbereich hinweg linear. Auch deutlich oberhalb der kritischen Konzentrationen ist die Konzentrationsentwicklung eindeutig linear, ohne die Steigung zu ändern. Dieses Verhalten bei dem erfindungsgemäßen Verzinnen wird in Beispiel 3 näher diskutiert.

Diese Ergebnisse sind parallel mit denjenigen, die sich aus der Analyse der erzielten Schichtdicke von Zinn ergeben. Hierbei zeigt sich, daß die Schichtdicke bei der Verzinnung von Kupfer ohne Beschichtung mit intrinsisch leitfähigem Polymer ab ca. 0,6 $m^2$/l (Fläche Kupfer pro Volumen Verzinnungslösung) deutlich abnimmt, während sie im Fall der erfindungsgemäß durchgeführten Verzinnung im wesentlichen konstant bleibt.

Daraus ergibt sich als praktischer Vorteil des erfindungsgemäßen Verfahrens, daß keine intermetallischen Phasen abgeschieden werden, die die beabsichtigte Funktion der Zinnschicht vermindern oder aufheben könnten, und pro Liter eingesetztem Verzinnungsbad eine mehr als doppelt so große Fläche beschichtet werden kann, als dies mit herkömmlichen chemischen Abscheidungsverfahren möglich ist.

Der Fall der Verzinnung von Kupfer nach dem erfindungsgemäßen Verfahren zeigt deutlich die katalytische Funktion des eingesetzten intrinsisch leitfähigen Polymeren. Es wird angenommen, daß bei dieser speziellen Metallisierung z.B. im Falle von Polyanilin als Polymer dieses von $Cu^0$ zu Leucoemeraldin reduziert wird, welches dann seinerseits $Sn^{2+}$ zur $Sn^0$ reduziert, während der vorhandene Sauerstoff Cu zu $Cu^{2+}$ oxidiert.

In jedem Fall führt das Eintauchen von einer mit dem Polymer beschichteten Kupferplatte in salzhaltiges Wasser bereits zur Reduktion von dem Polyanilin, was bei genügend großen Schichtdicken von Polyanilin, z.B. 1-5 µm, auch optisch anhand dessen Entfärbung festgestellt werden kann, die auf die Bildung des farblosen Leucomeraldins als reduzierte Form zurückzuführen ist.

Schließlich betrifft die Erfindung auch noch die Verwendung von intrinsisch leitfähigen Polymeren bei der nicht-elektrochemischen Aufbringung von Metallen auf Werkstoffe, indem man

(a) den zu metallisierenden Werkstoff mit einer Beschichtung versieht, die intrinsisch leitfähiges Polymer enthält,

(b) das intrinsisch leitfähige Polymer durch Reduktion aktiviert und

(c) das Metall auf den Werkstoff in nicht-elektrochemischer Weise aufbringt, indem der beschichtete Werkstoff mit einer Ionen des Metalles enthaltenden Lösung in Kontakt gebracht wird.

Die Erfindung wird im folgenden anhand von Beispielen näher erläutert.

Beispiele

Beispiel 1: **Metallisierung von Polyamid mit Kupfer**

Ein 4 Gew.-% Polyanilin enthaltender Polymerblend auf Polyamid-Basis, nämlich *Ormecon 900187/34* von Ormecon Chemie, Ahrensburg, wurde auf eine Polyamid-Folie aus *PA6 Ultramid B3L* von BASF mit einem Rakel in einer Schichtdicke von 100 µm aufgetragen. Die Beschichtung war grün. Die Folie wurde 20 Minuten lang bei 80°C getrocknet.

Zur Metallisierung wurde die beschichtete Folie in 1 N Natronlauge getaucht, die 13 g/l Hydraziniumsulfat enthielt, und dort bei Raumtemperatur für 24 Stunden unter Stickstoff zur Reduktion aufbewahrt. Beim Eintauchen in das Reduktionsmedium verfärbte sich die Beschichtung sofort tiefblau. Im Verlauf der Reduktion ging die Farbe der Polyanilin-Schicht in Grau über. Nach dem Herausziehen aus der Reduktionslösung wurde die Folie unter Stickstoff mit destilliertem Wasser abgespült und sofort in eine Lösung von 0,1 N Kupfertosylat/0,01 N Dodecylbenzolsulfonsäure mit einem pH-Wert von 4 überführt. Hier wurde sie zur Kupferabscheidung für 5 Stunden unter Stickstoff belassen. Die Farbe der Oberfläche schlug dabei in Grünbraun um. Nach anschließendem Spülen mit destilliertem Wasser wurde die Oberfläche zur Entfernung anhaftender Kupfersalze für eine Minute in wäßrige Ammoniak-Lösung getaucht. Nach erneutem Spülen mit Wasser wurde die nun bronzefarbene Folie an der Luft getrocknet.

Alle vorstehenden Behandlungen wurden, sofern nicht anders angegeben, bei Raumtemperatur durchgeführt, und die verwendeten Lösungen wurden vor Gebrauch frisch hergestellt, entgast und 5 Minuten mit Stickstoff gespült.

Durch Röntgenfluoreszenzanalyse unter Anregung mit Ge-Target bei 25 KV und 1,0 mA konnte das auf dem Polyanilin abgeschiedene Kupfer anhand von Peaks bei 8,05 und 8,91 KeV identifiziert werden.

Durch mehrmaliges Wiederholen der chemischen Redoxvorgänge, d.h. Reduktion und Metallabscheidung, konnte die Menge an abgeschiedenem Kupfer noch erhöht werden.

Beispiel 2: **Metallisierung von Polyethylenterephthalat mit Silber**

Ein 4% Gew.-% Polyanilin enthaltender Polymerblend auf Polyamid-Basis, nämlich der Lack *Ormecon 900187/34* von Ormecon, Ahrensburg, wurde mit einem Rakel in einer Schichtdicke von 50 µm auf eine Polyethylenterephthalat(PET)-Folie aufgetragen. Die mit dem Lack grün beschichtete PET-Folie wurde nach einer Trockendauer von 10 Minuten bei 80°C mit Silber metallisiert.

Hierzu wurde die beschichtete PET-Folie in Natronlauge getaucht, die 30 g/l Hydraziniumsulfat enthielt. Der pH-Wert der Lösung betrug 9 bis 10. Die Folie wurde für 12 Stunden zur Reduktion in dieser Lösung unter Stickstoff aufbewahrt. Nachdem sich die Beschichtung der Folie beim Eintauchen in die Lösung sofort blau verfärbte, hatte sie nach der Reduktion eine gelbe Farbe. Nach dem Herausziehen aus der Reduktionslösung wurde die Folie unter Stickstoff mit destilliertem Wasser abgespült und sofort in eine 0,33 molare para-Toluolsulfonsäure-Lösung mit einem pH-Wert 1, welche 11,2 g/l Silbernitrat enthielt, für 30 Minuten zur Silberabscheidung eingetaucht. Die Farbe der Oberfläche der Folie schlug dabei in Grün um. Nach wenigen Minuten war bereits eine Silberabscheidung zu erkennen. Nach dem Spülen mit destilliertem Wasser wurde die Folie an der Luft getrocknet.

Alle vorstehenden Behandlungen wurden, sofern nicht anders angegeben, bei Raumtemperatur durchgeführt, und die verwendeten Lösungen wurden vor Gebrauch frisch hergestellt, entgast und 5 Minuten mit Stickstoff gespült.

Mittels Röntgenfluoreszenzanalyse konnte das auf der Polyanilin-Beschichtung abgeschiedene Silber anhand von Peaks bei 2,98, 3,14 und 3,23 KeV eindeutig identifiziert werden. Daneben waren nur die Schwefelpeaks bei 2,30 und 2,47 KeV erkennbar, welche von den Gegenionen des Polyanilins stammten.

Beispiel 3: **Chemische Abscheidung von Zinn auf Kupfer**

Die Oberfläche von Kupferplatten wurde chemisch verzinnt. Dabei erfolgte die Verzinnung erfindungsgemäß mit Beschichtung der Kupferplatten mit einer wäßrigen Polyanilin-Dispersion, z.B. Ormecon 900236/04 der Firma Ormecon Chemie, Ahrensburg. Zum Vergleich wurde die Verzinnung auch ohne Polyanilin-Beschichtung durchgeführt.

**Ausführung**

Die Fläche der Kupferplatte, die verzinnt werden sollte, wurde durch Ausmessen bestimmt. Zum Entfetten der Oberfläche und zum Entfernen der Oxidschicht oder einer das Kupfer vor dem Anlaufen schützenden Zink- oder Chromatschicht wurde eine Mikroätzung der Platte durchgeführt. Die Kupferplatte wurde dazu bei Raumtemperatur für zwei Minuten in die handelsübliche Säure-Beize Circuposit Etch 3330 auf Basis von Schwefelsäure und Peroxid der Firma Shipley, Deutschland, getaucht. Anschließend wurde die Platte mit Wasser abgespült und zum Aufbringen einer Polyanilin-Beschichtung für eine Minute in eine wäßrige Polyanilin-Dispersion, nämlich das mit Wasser im Verhältnis 1:19 verdünnte *Ormecon 900236/04*-Konzentrat (Ormecon Chemie, Ahrensburg) getaucht. Nach dem Spülen mit Wasser wurde die Platte in der Verzinnungslösung *Tinposit LT-34 Immersion Tin*-Lösung (Shipley, Deutschland) bei 50°C nicht-elektrochemisch verzinnt, indem sie in diese Lösung eingetaucht wurde. Die Verzinnungslösung entwickelt $Sn^{2+}$-Ionen, Phenolsulfonsäure und Thioharnstoff. Die Abscheidungsreaktion setzte sofort beim Eintauchen der Platte ein. Die Platte wurde nach 20 Minuten aus dem Verzinnungsbad gezogen, mit Wasser gespült und getrocknet. Die Oberfläche war jetzt mit einer seidenmatten, silberfarbenen Zinnschicht überzogen.

Zum Vergleich wurden die obigen Schritte mit der Änderung wiederholt, daß eine Polyanilin-Beschichtung nicht aufgebracht wurde.

### Analytik

### A. Zinn-Bestimmung in der Tinposit LT-34 Immersion Tin-Lösung

Zinn, das in 2-wertiger Form vorlag, wurde in mit Natriumacetat gepufferter Lösung direkt mit Xylenolorange als Indikator durch Titration mit Titriplex III quantitativ bestimmt.

Ausführung der Bestimmung

2 ml der *Tinposit LT-34 Immersion Tin*-Lösung wurden mit Wasser auf 100 ml verdünnt, mit 1 ml konz. HCl versetzt und mit Natriumacetat auf einen pH-Wert von etwa 4 eingestellt. Nach Zugabe von Xylenolorange-Indikator-Verreibung wurde mit 0,1 N Titriplex III-Lösung von Violett bis zum letzten bleibenden Farbumschlag nach Hellgelb titriert.

Berechnung

1 ml 0,1 mol/l Titriplex III-Lösung = 11,869 mg Sn

### B. Kupfer-Bestimmung in der Tinposit LT-34 Immersion Tin-Lösung

Kupfer, das in 2-wertiger Form vorlag, wurde durch Zugabe von Ammoniak als Kupfertetramminkomplex spektralphotometrisch bestimmt.

Ausführung der Bestimmung

0,5 ml der *Tinposit LT-34 Immersion Tin*-Lösung wurden mit 5 ml konz. Ammoniak (25%, reinst) versetzt, gut geschüttelt, und der weiße Niederschlag von $Sn(OH)_2$ (eigentlich Zinn-II-oxidhydrat komplizierter Zusammensetzung) wurde nach etwa 5 Minuten mit einem Filtertiegel (Porosität 3) abfiltriert. Das klare Filtrat wurde in einer 10 mm Glasküvette im UV/Vis-Spektralphotometer im Bereich von 1000 bis 400 nm vermessen. Als Referenzspektrum wurde eine reine Ammoniaklösung (25%) verwendet. Aus der Extinktion des Maximums bei etwa 630 nm wurde mit Hilfe einer Eichgeraden die Kupferionenkonzentration bestimmt.

### Berechnung

Eichgerade:

$$y = 0,0913\ x + 0,035$$

mit

$$y = \text{gemessene Extinktion}$$

und

$$x = Cu^{2+} \text{ in g/l}$$

### C. Zinn-Bestimmung auf der Kupferoberfläche

Zur Bestimmung der Schichtdicke des auf dem Kupfer abgeschiedenen Zinns wurde das Zinn mit Säure aufgelöst und in der entstehenden Lösung durch Titration mit Titriplex III quantitativ bestimmt.

Ausführung der Bestimmung

Die verzinnte Kupferplatte wurde dazu bei 50°C für 10 Minuten in konzentrierte Salzsäure getaucht und anschließend mit Wasser abgespült. Spülwasser und die zum Ablösen verwendete Menge an Säure wurden zusammengegeben, mit Wasser auf 100 ml aufgefüllt und mit Natronlauge-Plätzchen auf einen pH-Wert von ungefähr 1 gebracht. Mit Natriumacetat wurde dann ein pH-Wert von etwa 4 eingestellt und nach Zugabe von Xylenolorange-Indikator-Verreibung wurde mit 0,1 N Titriplex III-Lösung von Violett bis zum letzten bleibenden Farbumschlag nach Hellgelb titriert.

### Meßergebnisse

Durch die analytischen Untersuchungen wurden der Zinn- und Kupfergehalt der *Tinposit LT-34 Immersion Tin*-Lösung in g/l für die jeweiligen $m^2$ verzinnter Kupferplattenoberfläche pro Liter Lösung ermittelt. Die Abnahme des Zinn-Gehalts und die Zunahme der Kupfer(II)-Konzentration wurden zum besseren Vergleich in mol/l umgerechnet. Die Bestimmung der Kupfer(II)-Konzentration erfolgte sofort nach Entnahme der verzinnten Platten und 48 Stunden nachdem das Verzinnungsbad bei Raumtemperatur an Luft gestanden hatte. Der Zinngehalt veränderte sich über diesen Zeitraum nicht, während beim Kupfer(II)-Gehalt eine starke Zunahme zu verzeichnen war. Diese resultierte vermutlich aus den in der Verzinnungs-Lösung vorhandenen Kupfer(I)-Ionen, die durch Luftsauerstoff langsam zu Kupfer(II)-Ionen oxidiert worden waren. Bei dem spektralphotometrischen Nachweis der KupferKonzentration wurden nur Cu(II)-Ionen erfaßt. Aus der Differenz der Kupfer(II)-Konzentration nach der sofortigen Entnahme und nach 48 Stunden ließ sich der Anteil der Kupfer(I)-Ionen in der Lösung direkt nach der Verzinnung bestimmen.

In den Figuren 1 und 2 sind Zinnabnahme und Kupferzunahme der Tinposit LT-34 Immersion Tin-Lösung gegen die $m^2$ an verzinnter Rupferoberfläche pro 1 eingesetzter Lösung aufgetragen. Dabei zeigt Figur 1 das Verhalten der erfindungsgemäß metallisierten Kupferplatte und Figur 2 das der zum Vergleich konventionell metallisierten Kupferplatte, welche nicht mit einer Polyanilin-Beschichtung versehen war.

Der Vergleich der Figuren 1 und 2 zeigt, daß bei der chemischen Verzinnung mit einer Vorbehandlung in einer wäßrigen Polyanilin-Dispersion über den gesamten Bereich eine lineare Zunahme der Kupferkonzentration bzw. eine Abnahme der Zinnkonzentration zu verzeichnen ist. Die Zinnabscheidung erfolgt bei Aufbringen einer Polyanilinschicht auch nach Überschreiten der eingezeichneten Grenze für den vom Hersteller der Verzinnungslösung garantierten Gültigkeitsbereich (Sn-Gehalt der Lösung > 18 g/l) noch mit gleicher Schichtdicke. Bei der Verzinnung ohne Polyanilin-Beschichtung tritt hingegen ab etwa 0,45 $m^2$/l verzinnter Fläche pro l Lösung eine negative Abweichung auf, und die Menge an abgeschiedenem Zinn nimmt beim Überschreiten der eingezeichneten Grenze ab.

**Patentansprüche**

1. Verfahren zur Herstellung von metallisierten Werkstoffen, bei dem man

    (a) den zu metallisierenden Werkstoff mit einer Beschichtung versieht, die intrinsisch leitfähiges Polymer enthält,

    (b) das intrinsisch leitfähige Polymer durch Reduktion aktiviert und

    (c) das Metall auf den Werkstoff in nicht-elektrochemischer Weise aufbringt, indem der beschichtete Werkstoff mit einer Ionen des Metalles enthaltenden Lösung in Kontakt gebracht wird.

2. Verfahren nach Anspruch 1, bei dem als intrinsisch leitfähiges Polymer Polyanilin verwendet wird.

3. Verfahren nach Anspruch 1 oder 2, bei dem das intrinsisch leitfähige Polymer in Form einer Dispersion verwendet wird.

4. Verfahren nach einem der Ansprüche 1 bis 3, bei dem als Beschichtung ein Polymerblend mit Gehalt an intrinsisch leitfähigem Polymer eingesetzt wird.

5. Verfahren nach einem der Ansprüche 1 bis 4, bei dem die Reduktion durch Einsatz von chemischen Reduktionsmitteln erfolgt.

6. Verfahren nach Anspruch 5, bei dem als chemische Reduktionsmittel $H_2$, Hydride und/oder gegenüber dem intrinsisch leitfähigen Polymer reduzierend wirkende Metalle eingesetzt werden.

7. Verfahren nach Anspruch 5 oder 6, bei dem als chemisches Reduktonsmittel Hydrazin oder Hydrazin-Verbindungen eingesetzt werden.

8. Verfahren nach einem der Ansprüche 1 bis 7, bei dem auf den Werkstoff die Hetalle Cu, Ag, Pd, Sn, Pt und/oder Ni aufgebracht werden.

9. Verfahren nach einem der Ansprüche 1 bis 8, bei dem eine Lösung eingesetzt wird, die ein- oder zweiwertige Kationen des abzuscheidenden Metalles enthält.

10. Verfahren nach einem der Ansprüche 1 bis 9, bei dem eine wäßrige Lösung eingesetzt wird, die einen pH-Wert von < 7 hat.

11. Verwendung von intrinsisch leitfähigen Polymeren bei der nicht-elektrochemischen Aufbringung von Metallen auf Werkstoffe, bei dem man

    (a) den zu metallisierenden Werkstoff mit einer Beschichtung versieht, die intrinsisch leitfähiges Polymer enthält,

    (b) das intrinsisch leitfähige Polymer durch Reduktion aktiviert und

    (c) das Metall auf den Werkstoff in nicht-elektrochemischer Weise aufbringt, indem der beschichtete Werkstoff mit einer Ionen des Metalles enthaltenden Lösung in Kontakt gebracht wird.

**Claims**

1. Process for the production of metallized materials, in which

    (a) the material to be metallized is provided with a coating which contains intrinsically conductive polymer,

(b) the intrinsically conductive polymer is activated by reduction and

(c) the metal is applied to the material in a non-electrochemical manner by bringing the coated material into contact with a solution containing ions of the metal.

2. Process according to Claim 1, in which polyaniline is used as intrinsically conductive polymer.

3. Process according to Claim 1 or 2, in which the intrinsically conductive polymer is used in the form of a dispersion.

4. Process according to any one of Claims 1 to 3, in which a polymer blend containing intrinsically conductive polymer is used as coating.

5. Process according to any one of Claims 1 to 4, in which the reduction takes place by using chemical reducing agents.

6. Process according to Claim 5, in which $H_2$, hydrides and/or metals having a reducing effect in respect of the intrinsically conductive polymer are used as chemical reducing agents.

7. Process according to Claim 5 or 6, in which hydrazine or hydrazine compounds are used as chemical reducing agent.

8. Process according to any one of Claims 1 to 7, in which the metals Cu, Ag, Pd, Sn, Pt and/or Ni are applied to the material.

9. Process according to any one of Claims 1 to 8, in which a solution is used which contains mono- or divalent cations of the metal to be deposited.

10. Process according to any one of Claims 1 to 9, in which an aqueous solution having a pH value of < 7 is used.

11. Use of intrinsically conductive polymers in the non-electrochemical application of metals to materials, in which

(a) the material to be metallized is provided with a coating which contains intrinsically conductive polymer,

(b) the intrinsically conductive polymer is activated by reduction and

(c) the metal is applied to the material in a non-electrochemical manner by bringing the coated material into contact with a solution containing ions of the metal.

## Revendications

1. Procédé pour la production de matériaux métallisés, selon lequel

(a) on applique au matériau à métalliser un revêtement, qui contient un polymère intrinsèquement conducteur,
(b) on active par réduction le polymère intrinsèquement conducteur, et
(c) on applique le métal sur le matériau d'une manière non électrochimique, en plaçant le matériau recouvert en contact avec une solution contenant des ions du métal.

2. Procédé selon la revendication 1, selon lequel on utilise de la polyaniline en tant que polymère intrinsèquement conducteur.

3. Procédé selon la revendication 1 ou 2, selon lequel on utilise le polymère intrinsèquement conducteur sous la forme d'une dispersion.

4. Procédé selon l'une des revendications 1 à 3, selon lequel on utilise comme revêtement un mélange polymère comportant une teneur de polymère intrinsèquement conducteur.

5. Procédé selon l'une des revendications 1 à 4, selon lequel la réduction s'effectue moyennant l'utilisation d'agents réducteurs chimiques.

6. Procédé selon la revendication 5, selon lequel on utilise comme agents réducteurs chimiques du $H_2$, des hydrures et/ou des métaux ayant une action de réduction par rapport au polymère intrinsèquement conducteur.

7. Procédé selon la revendication 5 ou 6, selon lequel on utilise comme agent réducteur chimique de l'hydrazine ou des composés de l'hydrazine.

8. Procédé selon l'une des revendications 1 à 7, selon lequel on dépose sur le matériau les métaux Cu, Ag, Pd, Sn, Pt et/ou Ni.

9. Procédé selon l'une des revendications 1 à 8, selon lequel on utilise une solution qui contient un cation monovalent ou bivalent du métal devant être déposé.

10. Procédé selon l'une des revendications 1 à 9, selon lequel on utilise une solution aqueuse dont la valeur du pH est < 7.

**11.** Utilisation de polymère intrinsèquement conducteur lors du dépôt non électrochimique de métaux sur des matériaux, selon laquelle,

(a) on applique au matériau à métalliser un revêtement, qui contient un polymère intrinsèquement conducteur,
(b) on active par réduction le polymère intrinsèquement conducteur, et
(c) on applique le métal sur le matériau d'une manière non électrochimique, en plaçant le matériau recouvert en contact avec une solution contenant des ions du métal.

**FIGUR 1**

**FIGUR 2**